# EUROPEAN PATENT APPLICATION

(11) **EP 2 827 357 A1**
(43) Date of publication of application: **21.01.2015**
(21) Application number: 13176980.4
(22) Date of filing: 18.07.2013
(51) Int. Cl.: H01J 37/141, H01J 37/14

(54) **Magnetic lens for focusing a beam of charged particles**

(71) Applicant: FEI COMPANY, Hillsboro, Oregon 97124-5793 (US)
(72) Inventor: Shanel, Ondrej, 79326 Vrbno pod Pradedem (CZ)
(74) Representative: Bakker, Hendrik

(57) **Abstract**

Prior art magnetic charged particle lens show a yoke and an air gap. The air gap defines the position where a magnetic field is present on the optical axis of the lens. A lens (10) according to the invention has no air gap, but uses a part (15) of the yoke (13 + 16) that is saturated. This results in a lens with lower spherical aberration due to a more gradual break-out of the magnetic field. This also eliminates the alignment problems that prior art lenses show between upper and lower pole pieces. Preferably the part of the yoke that is saturated is an insert (16), resulting in better tolerances, better machinability and lower cost due to smaller size. Also, the insert (16) may show magnetic properties different from the rest of the yoke (13).

## Description

The invention concerns a magnetic lens for focusing a beam of charged particles, the beam of charged particles travelling along an optical axis, the lens comprising:
- a central bore round the optical axis for passing the beam of charged particles,
- magnetic field generating means, and
- a magnetic yoke to guide and concentrate the magnetic field to the optical axis to form a focusing area, the resulting magnetic field causing focusing of the charged particles in the focusing area.

Such a magnetic lens is known from, for example electron microscopy, and is described, for example, in "Scanning Electron Microscopy", L. Reimer, Springer Verlag Berlin Heidelberg (1985), ISBN 3-540-13530-8, more specifically from chapter 2.2.1: Electron lenses (pages 20 - 23).

Reimer shows a magnetic lens with an electric coil for generating a magnetic field and iron pole pieces (also called the yoke), the pole pieces concentrating the magnetic field to a rotational symmetric axial field on the symmetry axis of the lens. Charged particles (electrons) travelling through the axial field are subject to the Lorentz force and experience a focusing effect.

The strength of the lens (its focal length) is a function of its excitation (current and turns in the electric coil) and the mass and energy of the charged particles. Magnetic lenses are typically used for electrons, while for ions often electrostatic lenses are preferred.

As is known to the skilled person the pole pieces must be well aligned. When the pole pieces are mis-aligned (that is: the symmetry axis of one pole piece does not coincide with the symmetry axis of the other pole piece) the lens axis is skewed, and the amount of skew is a function of the strength of the lens. Due to the resulting maximum mechanical tolerances, often +/- 10 µm or less, pole pieces are expensive parts. A complication to that is that the magnetic material should have low hysteresis. For that the material is typically annealed, and only a very small last machining with low clamping forces is allowed.

Another problem with conventional lenses is that the gap between the pole pieces also passes magnetic stray fields perpendicular to the optical axis. Such perpendicular fields, including 50 Hz magnetic fields, can lead to interferences of the beam passing through the lens, or are an independent source of skew.

For information about magnetic material reference is made to "Weichmagnetische Werkstoffe, R. Boll, Vacuum Schmelze, ISBN 3-80090154604.

There is a need for a lens with improved and easier alignment, easier machining leading to lower costs, and improved shielding to perpendicular magnetic stray fields, preferably with improved optical characteristics Cₛ.

The invention intends to provide a solution to at least some of these problems.

To that end the magnetic lens according to the invention is characterized in that the focusing area is surrounded by a part of the magnetic yoke that, in working, is magnetically saturated.

The invention is based on the insight that, by saturating the material surrounding the focusing area, excess magnetic field breaks out and contributes to a symmetric axial field.

As the part where the magnetic axial field is generated (the part that is saturated) corresponds to two pole pieces and the gap between them, the mis-alignment that often occurs when using prior art pole pieces cannot occur. Only the mechanical alignment (tolerance) of the bore of the saturated part is of importance.

As the material surrounding the focusing volume is saturated in the axial direction only, perpendicular to that axis the permeability µᵣ is high. Therefore the shielding is much higher than in conventional lenses employing an air gap.

It is noted that, although it might seem to be a simple design feature to replace the gap in a magnetic lens with saturated material, it is not something obvious to the person skilled in the art, for the following reasons:
- Saturating the yoke implies that when using the lens at a high excitation the amount of saturated material is larger than when using the lens with a low excitation. This can be thought to be equivalent to a dimensional change in the gap of a standard lens, and the resulting lens strength will change with the excitation. For the focusing of charged particles with a four times higher energy a standard lens would need an excitation with approximately twice the lens current, but for a lens according to the invention the excitation might be quite different due to the change in the amount of saturated material.
- Also, designing a lens is usually done using Finite Element Modeling (FEM), and, in modern programs, for each of the elements (corresponding to voxels) in the simulation the µᵣ is calculated for each iteration. The number of iterations grows steeply when more voxels are more heavily saturated. Therefore designers prefer lens designs with little saturated material.
- The lens current needed to operate a lens according to the invention needs more ampere-turns, as some of the current is used to saturate the material without causing an axial magnetic field. In standard lenses this amount of current is already available to generate a magnetic field in the gap, and thus contributes to the axial magnetic field.

Microscope designers thus have several reasons to keep the amount of material that is saturated as low as possible, for example limited to the edges defining the gap.

Furthermore inventor found that the use of a shape with saturated material results in a smoother axial field change (lower dB/dz, with z along the optical axis), resulting in lower lens aberrations compared to prior art lenses with similar size of the focusing area. This is the result of the more gradual break-out of the magnetic field from the saturated material, compared to the abrupt step that is made at the boundary of material at the air gap in a prior art gap lens.

In an embodiment the magnetic field generating means comprise permanent magnets, electric coils, or a combination thereof.

Lenses with permanent magnets are well known, having the advantage that no power is consumed. Lenses employing electric coils are used more often as they allow a change in field strength (and thus optical behavior) by changing the electrical current. The combination of both allows a lens where most of the magnetic field is generated by the permanent magnets, while a variation of the field (higher or lower) can be achieved by excitation of the electrical coil.

In another embodiment the magnetic saturation reduced the incremental permeability µ_{Δ,sat} to at most 10% of the maximum incremental permeability µ_{Δ,max}, more specifically at most 1% of the maximum incremental permeability µ_{Δ,max}.

By defining saturation in terms of incremental permeability µ_{Δ} = δB/δH, µ_{Δ,sat} < µ_{Δ,peak}/10 respectively µ_{Δ,sat} < µ_{Δ,peak}/100 at a magnetic field above the magnetic field where µ_{Δ,peak} occurs), an objective value for the saturation is given, instead of the often used definition of "asymptotic value".

In a preferred embodiment the yoke comprises parts of different magnetic properties.

In this embodiment only a small part needs to be of high quality magnetic material and be machined to a high accuracy, and be annealed to the highest magnetic standards, while other parts of the yoke can have materials of lower prices, relaxed tolerances, magnetic quality and/or annealing, resulting in cheaper parts that are easier handled. The advantage is that the parts with relaxed tolerances can be made of a cheaper material that can be better machined as well.

In yet another embodiment the part that, in working, is magnetically saturated, is part of an insert with an outer diameter that is at the position where saturation occurs smaller than the diameter elsewhere, the insert inserted in another part of the yoke.

The part of the insert with a reduced outer diameter is the part where saturation occurs. Bordering this part with reduced outer diameter the insert shows a larger outer diameter, and therefore the magnetization will be lower, resulting in a less saturated material. At yet other positions the insert has a diameter made to fit in other parts of the yoke, so that the magnetic field can traverse from one part to the other.

In still another embodiment the part that, in working, is magnetically saturated, is part of an insert, the insert having an inner diameter that differs from the part or part in which it is inserted.

The insert can have another inner diameter than the other parts, preferably a smaller inner diameter. More specifically, only the tolerances of the insert need to be high, tolerances on other parts can be more relaxed.

In yet another embodiment the part comprising the magnetically saturated material is a ferromagnetic material or a material comprising ferrite, the material showing low hysteresis.

Examples of low hysteresis ferromagnetic materials are materials mainly consisting of (pure or as a mixture) Fe, Co, and/or Ni with traces of, for example, Cu, Mo, Si, Va, and/or Cr.

Also a ferrite (FeO and such, also used for RF interference suppressors) can be used.

In yet another embodiment the lens forms a vacuum seal with other parts arranged along the optical axis.

By forming the lens such, that vacuum seals are formed with other parts arranged round the optical axis, a simple yet effective way of stacking these parts together. Aligning the parts can be done by, e.g., the principle described in Dutch patent number NL 1025037.

In yet another embodiment in the bore particle-optical elements are placed from the group of detectors, deflectors, electrostatic lens elements or magnetic, electrostatic or combined electrostatic/magnetic multipoles, correctors and/or auxiliary lenses.

Positioning other optical elements in the mechanical part of the lens allows optimum freedom to place optical elements where needed.

In yet another embodiment the magnetic lens of any of the preceding claims in which the lens shows an auxiliary electric coil that in working surrounds the magnetically saturated part without surrounding unsaturated parts, the inductance of the auxiliary electric coil thus lower than the inductance of a similar electrical coil surrounding non-saturated material, as a result of which high frequency changes in the strength of the lens can be made.

In some cases it is desired to make fast changes to the strength of a lens. In conventional lenses this implies the use of an auxiliary coil in the bore of a lens. For several reasons this may be undesirable, for example problems related to cooling, for servicing, etc. By placing the coil outside the vacuum barrier on the insert these problems are avoided. As the ferro-magnetic material is saturated, the coil surrounds material with a differential permeability µ_{Δ} = 1, and thus for variations of the field the saturated material behaves like air.

It is noted that magnetic materials often change dimensions when magnetized. This effect is known as magnetostriction. Preferably the dimensions of the insert and the bore in which the insert are inserted are such that no undue pressures occur when inserting the insert, or when magnetizing the insert.

The invention is now elucidated using figures, in which identical reference numerals refer to corresponding features.

To that end:
Figure 1 schematically shows a magnetic lens according to the invention,
Figure 2 schematically shows a detail of figure 1, comprising the insert,
Figure 3 schematically shows a detail of figure 1, comprising the insert with an auxiliary coil,
Figure 4 schematically shows a detail of figure 1, comprising an alternative insert
Figure 5 schematically shows the relation between B(H) and µᵣ(H).

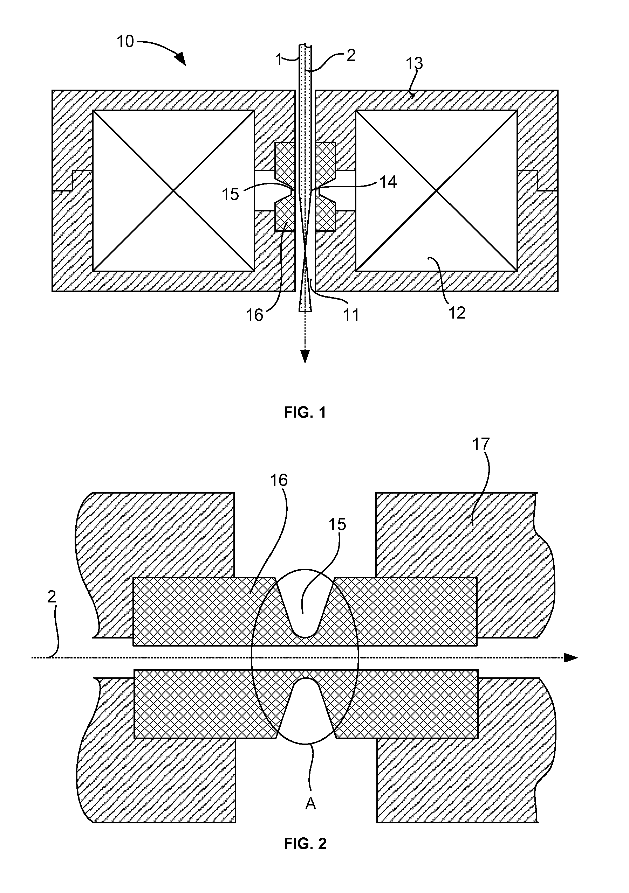

Figure 1 schematically shows a magnetic lens according to the invention.

A beam of charged particles 1 travels along an optical axis 2. Round the optical axis 2 a rotationally symmetric lens 10 shows a magnetic yoke 13 and an electric coil 12. The magnetic yoke 13 comprises a central bore 11 and an insert 16, the insert showing a part 15 with a reduced outer diameter. This part 15 is magnetically saturated, as a result of which an axial magnetic field is formed in focusing are 14. Part 15 is of a high magnetic quality, while the rest of the yoke can be of a lower magnetic quality, for example due to material with another (magnetically inferior) composition, other annealing, machining, etc.

Figure 2 schematically shows a detail of figure 1, comprising the insert.

The insert shows a neck 15 with reduced outer diameter. As a result the neck shows less magnetic material, and saturates much earlier than the adjacent parts. The insert 16 is of a higher magnetic quality than the other part 17 of the yoke.

As the saturation is mainly governed by the material within area A, only the bore and diameters in area A need to be machined to a high accuracy. The magnetic properties of material outside area A is of less importance, as is the quality of the "inferior" magnetic parts 17.
As shown here the saturated part need not have a constant outer diameter, also a spline or such can be used.

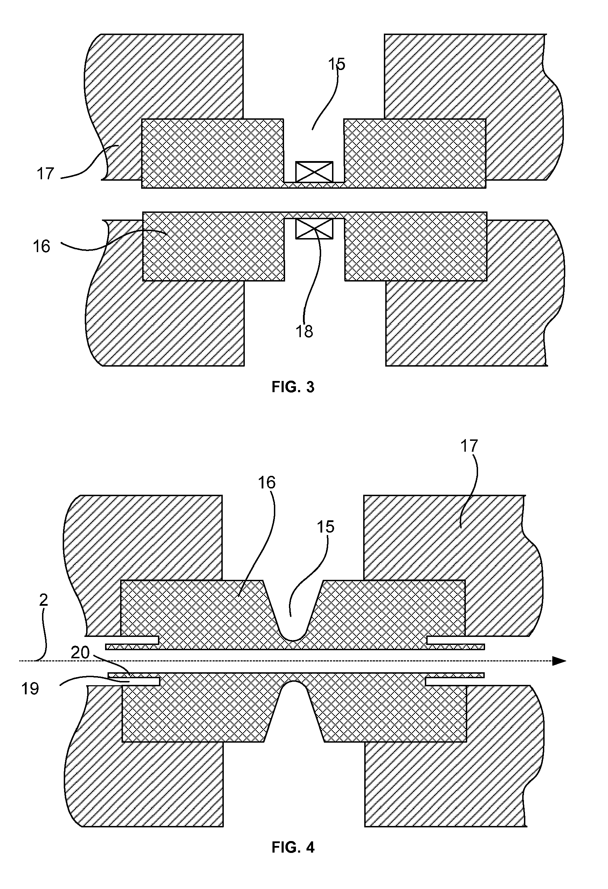

Figure 3 schematically shows a lens with an insert and an auxiliary coil for high frequency lens modulation.

Figure 3 shows an insert 16 with a neck portion 15. Surrounding the neck portion an auxiliary coil 18 is placed, the auxiliary coil in working thus surrounding saturated material. As a result the inductance of the coil is low and the lens strength can be varied with a high frequency: for an axial field along the optical axis no shielding due to eddy currents occurs.

Figure 4 schematically shows a detail of figure 1, comprising an alternative insert

The insert shows a groove 19, causing a part 20 to be separated from the rest of the yoke. Because these parts are magnetically free-standing, they shield the axial region from magnetic field. Preferably the free-hanging part of the insert extends beyond the joints where the insert is pressed against the rest of the yoke, thus avoiding a break-out of the magnetic field at the joints to cause an axial field.

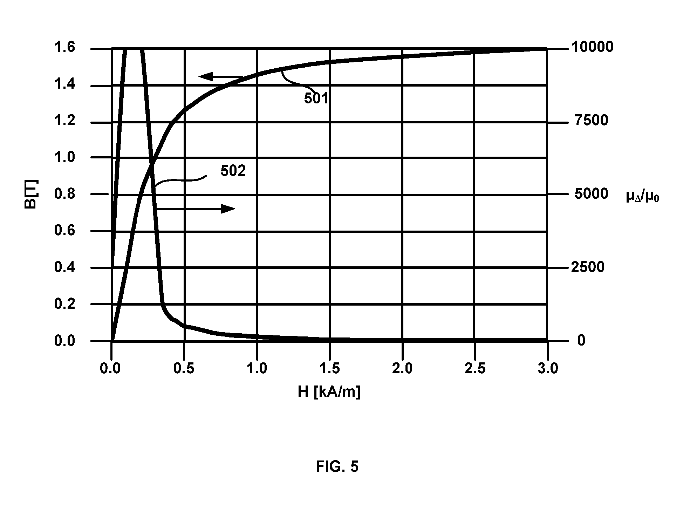

Figure 5 schematically shows a B-H curve of a ferromagnetic material and the incremental permeability µ_{Δ} = δB/δH.

B, the magnetic field strength in Tesla, is the result of H, expressed in A/m. The relationship between the two is B = µH = µ₀ µᵣ H. The curve shown is exemplary for pure (99.98%) Fe, also known as magnet iron. As seen in this curve the material saturates at a field strength of approximately 1.5 T, and as known to the skilled person a well annealed part of pure iron has a maximum µᵣ of 40000. For completely saturated material the field B still increases, but the derivative δB/δH then equals µ₀, identical to air. The derivative δB/δH is also known as the incremental permeability µ_{Δ}.

For practical reasons "saturated" is here defined as the field strength B for which µ_{Δ} equals µ_{Δ,max} /10, more specifically µ_{Δ,max} / 100.

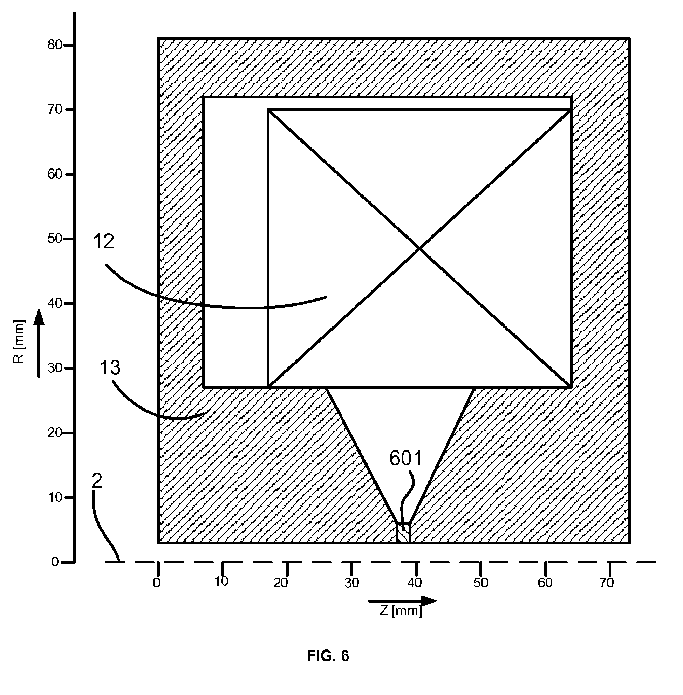

Figure 6 schematically shows the lens design used in two simulations.

Figure 6 shows half of a lens, the lens rotationally symmetric round the optical axis 2, The lens comprises a yoke 13 and a coil 12 to magnetize the yoke. The material used in the simulation is pure iron, with the BH curve and µ_{Δ} shown in figure 5. The difference in the two simulation is that in the first simulation part 601 is absent. This represents a prior art lens with an air gap. In the second simulation part 601 is made of the same pure iron as used in the rest of the simulated yoke.

In the first simulation for a lens with an air gap the excitation of the lens, 3133 Ampere turns, is chosen to result in a focal length of 7,27 mm. In the second simulation for a lens according to the invention, without an airgap, another excitation is chosen: 3548 Ampere turns, as a result of which the focal length for both simulations is

As known to the person skilled in the art of (charged optical) lens design the spherical aberration Cs and the chromatic aberration Cc are important parameters for such lenses. The lower, the better. Simulations show the following characteristics:

**Table 1: simulated lens characteristics for the lens shown in figure 6**

| | Fobj [mm] | NI [A·t] | Cs [mm] | Cc [mm] |
|---|---|---|---|---|
| With air gap | 7,27 | 3133 | 22,9 | 6,4 |
| Without air gap | 7,27 | 3548 | 14,9 | 6,2 |

The improvement of 35% in spherical aberration is a large improvement, and results for a spot that is limited by spherical aberration for example in a doubling in current density in the same spot diameter, or a 35% decrease in spot size for the same spot current.

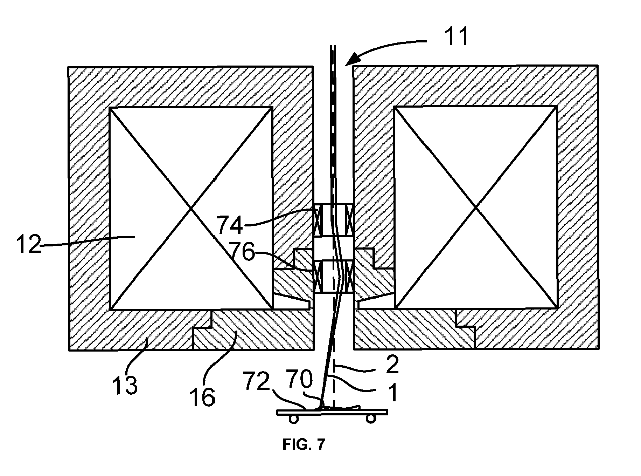

Figure 7 shows an objective lens for a Scanning Electron Microscope. Here the focusing area is close to one side of the lens.

The lens shows a yoke 13 with an insert 16. In the yoke a coil 12 is placed for magnetizing the yoke and insert. Inside the bore 11 two deflectors 74 and 76 are placed for positioning the beam 1 on the sample 70. The sample 70 is placed on a sample manipulator 72. As known to the skilled person two deflectors should be used to pass the beam through the focusing area of the lens and deflect the beam from the optical axis 2. Other optical components, such as stigmators or detectors, may be placed in the bore as well.

It is noted that in this invention charged particles are mentioned. Charged particles comprise electrons, ions, and charged molecules. However, the use of magnetic lenses is especially useful when manipulating electrons due to their mass/charge ratio. However, the use of ions, specifically hydrogen and helium ions, is specifically mentioned.

It is also noted that a beneficial effect is that the power dissipation of the lenses is more constant than for prior art lenses, as part of the power is needed to saturate to part of the yoke. This implies that always a "zero load" must be used for saturating the yoke, and the rest of the power is used to cause the magnetic axial field.

In conclusion prior art magnetic charged particle lens show a yoke and an air gap. The air gap defines the position where a magnetic field is present on the optical axis of the lens. A lens (10) according to the invention has no air gap, but uses a part (15) of the yoke (13 + 16) that is saturated. This results in a lens with lower spherical aberration due to a more gradual break-out of the magnetic field. This also eliminates the alignment problems that prior art lenses show between upper and lower pole pieces. Preferably the part of the yoke that is saturated is an insert (16), resulting in better tolerances, better machinability and lower cost due to smaller size. Also, the insert may show magnetic properties different from the rest of the yoke.

## Claims

1. A magnetic lens (10) for focusing a beam of charged particles (1), the beam of charged particles travelling along an optical axis (2), the lens comprising:
• a central bore (11) round the optical axis for passing the beam of charged particles,
• magnetic field generating means, and
• a magnetic yoke (13 + 16) to guide and concentrate the magnetic field to the optical axis to form a focusing area (14), the magnetic field causing focusing of the charged particles in the focusing area,
**characterized in that**
• the focusing area is surrounded by a part (15) of the magnetic yoke (13 + 16) that, in working, is magnetically saturated, thereby causing the focusing magnetic field at the optical axis.

2. The magnetic lens (10) of claim any of the preceding claims in which the magnetic field generating means comprise permanent magnets, electric coils (12), or a combination thereof.

3. The magnetic lens (10) of any of the preceding claims in which the magnetic saturation reduced the incremental permeability µ_{Δ} in the direction of the focusing magnetic field to at most 10% of the maximum attainable incremental permeability µ_{Δ,max}, more specifically to at most 1% of the maximum attainable incremental permeability µ_{Δ,max}.

4. The magnetic lens (10) of any of the preceding claims in which the yoke (13 + 16) comprises parts with different magnetic properties.

5. The magnetic lens of any of the preceding claims in which the part that, in working, is magnetically saturated, is part of an insert (16) with an outer diameter that is at the position where saturation occurs smaller than the diameter elsewhere, the insert inserted in another part (13) of the yoke.

6. The magnetic lens of any of the preceding claims in which the part that, in working, is magnetically saturated, is part of an insert (16), the insert having an inner diameter that differs from the part or part (13) in which it is inserted.

7. The magnetic lens of any of the preceding claims in which the part (16) comprising the magnetically saturated material is a ferromagnetic material or a material comprising ferrite, the material showing low hysteresis.

8. The magnetic lens of any of the preceding claims in which the lens forms a vacuum seal with other parts arranged along the optical axis.

9. The magnetic lens of any of the preceding claims in which in the bore (11) particle-optical elements are placed from the group of detectors, deflectors(74, 76), electrostatic lens elements or magnetic, electrostatic or combined electrostatic/magnetic multipoles, correctors and/or auxiliary lenses.

10. The magnetic lens of any of the preceding claims in which the lens shows an auxiliary electric coil (18) that in working surrounds the magnetically saturated part without surrounding unsaturated parts, the inductance of the auxiliary electric coil thus lower than the inductance of a similar electrical coil surrounding non-saturated material, as a result of which high frequency changes in the strength of the lens can be made.
